# EUROPEAN PATENT APPLICATION

(11) **EP 1 271 607 A2**
(43) Date of publication of application: **02.01.2003**
(21) Application number: 02012292.5
(22) Date of filing: 05.06.2002
(51) Int. Cl.: H01J 37/32

(54) **Chemical vapor deposition apparatus and method**

(30) Priority: 18.06.2001 JP 2001182854
(71) Applicant: JAPAN PIONICS CO., LTD., Minato-ku, Tokyo 105 (JP); Tokushima Sanso Co., Ltd., Tokushima-shi, Tokushima (JP)
(72) Inventor: Sakai, Shiro, Tokushima-shi, Tokushima (JP); Takamatsu, Yukichi, Hiratsuka-shi, Kanagawa (JP); Mori, Yuji, 5181, Tamura, Hiratsuka-shi, Kanagawa (JP); Wang, Hong Xing, University of Tokushima,, Tokushima-shi, Tokushima (JP); Komiya, Yoshinao, 5181, Tamura, Hiratsuka-shi, Kanagawa (JP); Kureha, Reiji, 5181, Tamura, Hiratsuka-shi, Kanagawa (JP); Ishihama, Yoshiyasu, 5181, Tamura, Hiratsuka-shi, Kanagawa (JP); Amijima, Yutaka, 5181, Tamura, Hiratsuka-shi, Kanagawa (JP)
(74) Representative: Gille Hrabal Struck Neidlein Prop Roos

(57) **Abstract**

There is disclosed a chemical vapor deposition apparatus of semi-conductor film comprising a horizontal type reaction tube equipped with a susceptor to carry a substrate, a heater to heat the substrate, an ingredient gas introduction zone arranged in a way that feeding direction to the reaction tube of the ingredient gas becomes substantially parallel to the substrate, and a reaction gas exhaust division, and further having a pressurized gas introduction zone on the wall of the reaction tube facing the substrate, wherein the structure of at least one part of the pressurized gas introduction zone at an upstream side of an ingredient gas passageway is such that the pressurized gas supplied from said part of the pressurized gas introduction zone is fed in an oblique down or a horizontal direction oriented to a downstream side of the ingredient gas passageway. Also, disclosed herein a chemical vapor deposition method using the apparatus. Thereby a uniform semiconductor film with good crystallinity is obtained even in the case of effecting chemical vapor deposition of a large-size substrate, or plural of substrates at the same time, or at elevated temperatures.

## Description

### FIELD OF THE INVENTION

The present invention relates to a chemical vapor deposition apparatus for semi-conductor film and chemical vapor deposition method for semi-conductor film. More particularly, the present invention relates to a chemical vapor deposition apparatus and a chemical vapor deposition method that efficiently promotes vapor phase epitaxy of a semi-conductor film with good uniformity and crystallinity on a heated substrate by introducing ingredient gas onto the substrate from a gas introduction zone of the horizontal type reaction tube arranged in a way that feeding direction of the ingredient gas to the reaction tube becomes substantially parallel to the substrate.

### BACKGROUND OF THE INVENTION

In recent years, a demand for a gallium nitride series compound semiconductor as the elements such as light emitting diode or laser diode is rapidly increasing mainly in optical communication field. As a manufacturing method of gallium nitride series compound semiconductor, a chemical vapor deposition method that forms semi-conductor film of gallium nitride series compound on the surface of a substrate of sapphire, etc. set preparedly in a reaction tube by a vapor phase epitaxy, using organic metal gas of, for example, trimethylgallium, trimethylindium or trimethylaluminum, etc. as group III metal source, and ammonia as nitrogen source is generally known.

At the same time, as an apparatus to produce gallium nitride series compound semiconductor, there is a chemical vapor deposition apparatus comprising a horizontal type reaction tube including a susceptor to carry a substrate, a heater to heat the substrate, an ingredient gas introduction division arranged in a way that feeding direction to the reaction tube of the ingredient gas becomes parallel to the substrate, and a reaction gas exhaust zone. In the chemical vapor deposition apparatus having this horizontal type reaction tube, a chemical vapor deposition method that forms a semi-conductor film by vapor phase epitaxy on the surface of a substrate by placing the substrate on the susceptor in the reaction tube, after having heated the substrate with a heater, feeding gas containing ingredient along the direction parallel to the substrate is adopted.
In such a horizontal type reaction tube, there were problems that any semi-conductor film with uniform and good crystallinity is not obtained or that the growth rate of the vapor phase epitaxy is late because the ingredient gas spreads by heat convection in the neighborhood of the substrate and does not efficiently arrive at the substrate. However, in recent years, the chemical vapor deposition apparatus or the chemical vapor deposition method that changed the flow direction of the ingredient gas to the direction toward the substrate is developed by providing a pressurized gas introduction zone on the wall of the reaction tube facing to the substrate, and by feeding the pressurized gas that does not give influence to reaction of a carrier gas, etc. vertically toward the substrate in the reaction tube.

According to this technology, a semi-conductor film of good crystallinity is reportedly obtained by appropriately controlling the flow rate of the pressurized gas depending on the kinds and the flow rate of ingredient gas, and a heating temperature of the substrate, etc. Unfortunately however, according to said chemical vapor deposition apparatus or said chemical vapor deposition method, there were many cases that the controlling of the pressurized gas flow was difficult due to the tendency of easily generating disturbance of the gas flow because the perpendicularly fed gas flows, namely the gas containing ingredients and the pressurized gas were mixed each other on the substrate.

For example, in the case of promoting the vapor phase epitaxy on large-scale substrate or promoting simultaneous vapor phase epitaxy on the substrate of plural pieces, it was difficult to feed the ingredient gas with a homogeneous density over a wide area of the substrate. Moreover, in the case of promoting the vapor phase epitaxy using above-mentioned trimethylgallium, trimethylindium or trimethylaluminum as the ingredient, it was also difficult to control the gas flow due to the generation of a complex gas flow on the substrate because high-temperature of 1000 °C or more was necessary as heating temperature of the substrate.

### SUMMARY OF THE INVENTION

Therefore, an object of the present invention is to provide a chemical vapor deposition apparatus or a chemical vapor deposition method using the horizontal type reaction tube, enabling to efficiently promotes vapor phase epitaxy of a semi-conductor film with good uniformity and crystallinity on the substrate even in the case of promoting the vapor phase epitaxy on large-scale substrate or promoting simultaneous vapor phase epitaxy on the substrate of plural pieces, or in the case of promoting the vapor phase epitaxy by adjusting at high temperature.

As a result of zealously repeated study by the inventors in order to achieve said objects, it was found out that the disturbance of the gas flow caused by the mixing of the gas containing ingredients and the pressurized gas on the substrate is relaxed by feeding at least one part of the pressurized gas supplied from a pressurized gas introduction zone at an upstream side of an ingredient gas passageway in an oblique or a horizontal direction oriented to a downstream side of the ingredient gas passageway. This invention was completed based on these findings. That is, the present invention provides a chemical vapor deposition apparatus of semi-conductor film comprising a horizontal type reaction tube equipped with a susceptor to carry a substrate, a heater to heat the substrate, an ingredient gas introduction zone arranged in a way that feeding direction to the reaction tube of the ingredient gas becomes substantially parallel to the substrate, and a reaction gas exhaust division, and further having a pressurized gas introduction zone on the wall of the reaction tube facing the substrate, wherein the structure of at least one part of the pressurized gas introduction zone at an upstream side of an ingredient gas passageway is such that the pressurized gas supplied from said part of the pressurized gas introduction zone is fed in an oblique down or a horizontal direction oriented to a downstream side of the ingredient gas passageway.

Moreover, the present invention provides a chemical vapor deposition method of semi-conductor film on a substrate comprising the steps of mounting a substrate on a susceptor in a horizontal type reaction tube, heating the substrate with a heater, and supplying a gas containing ingredients in a way that feeding direction to the reaction tube of the gas becomes substantially parallel to the substrate, and supplying the pressurized gas from the pressurized gas introduction zone on the wall of the reaction tube facing the substrate characterized in that at least one part of the pressurized gas supplied from a pressurized gas introduction zone at an upstream side of an ingredient gas passageway is fed in an oblique down or a horizontal direction oriented to a downstream side of the ingredient gas passageway.

### BRIEF DESCRIPTIONOF THE DRAWINGS

FIG.1 is a vertical sectional view showing an embodiment of a chemical vapor deposition apparatus of this invention;
FIG. 2 is a vertical sectional view showing a structure of an embodiment of the pressurized gas introduction zone for feeding the pressurized gas obliquely downward or horizontally; and
FIG. 3 is a plan view showing distributional examples of the pressurized gas introduction zone for feeding the pressurized gas obliquely downward or horizontally and the pressurized gas introduction zone for feeding the pressurized gas down toward a substrate.

### DESCRIPTION OF THE PREFERRED EMBODIMENTS

The chemical vapor deposition apparatus and the chemical vapor deposition method for semi-conductor film of the present invention promotes vapor phase epitaxy of a semi-conductor film by carrying a substrate on a susceptor in a horizontal type reaction tube, heating the substrate with a heater, supplying a gas containing ingredients in a way that feeding direction to the reaction tube of the gas becomes substantially parallel to the substrate, and supplying the pressurized gas from the pressurized gas introduction zone on the wall of the reaction tube facing the substrate.

The chemical vapor deposition apparatus of the present invention has a structure characterized in that at least one part of the pressurized gas introduction zone at an upstream side of an ingredient gas passageway is such that the pressurized gas supplied from said part of the pressurized gas introduction zone is fed in an oblique down or a horizontal direction oriented to a downstream side of the ingredient gas passageway.

Moreover, the chemical vapor deposition method of this invention is characterized in that that at least one part of the pressurized gas supplied from a pressurized gas introduction zone at an upstream side of an ingredient gas passageway is fed in an oblique down or a horizontal direction oriented to a downstream side of the ingredient gas passageway.

In the chemical vapor deposition apparatus and the chemical vapor deposition method for semi-conductor film of the present invention, there are not any special limitation regarding the kind, the dimension, and the quantity of the substrate, or the kind, the flow rate, etc. of the ingredient gas. However, regarding the substrate, advantages offered by the present invention will be sufficiently recognized particularly in the case of promoting vapor phase epitaxy of large-scale substrate with a diameter of 4 inches or more or in the case of promoting simultaneous vapor phase epitaxy of six pieces of the substrate, etc. in the viewpoint of enabling to reduce disturbance of the gas or scatter of the ingredient gas by heat convection over a wide area of the substrate. Typical examples of the substrate are sapphire, SiC, and a bulk galliumnitride, etc.

Furthermore, regarding the kind of the ingredient gas, advantages offered by the present invention will be sufficiently recognized particularly in the case of promoting vapor phase epitaxy demanded that the heating temperature of the substrate 1000 °C or more, in the viewpoint of that it enables to reduce disturbance of the gas or scatter of the ingredient gas by heat convection over a wide area of the substrate.

Typical example of the chemical vapor deposition method employing these ingredient gasses is vapor phase epitaxy of gallium nitride series compound semiconductor using trimethylgallium, triethylgallium, trimethylindium, triethylindium, trimethylaluminum or triethylaluminium as III group metal source and using ammonia, monomethylhydrazine, dimethylhydrazine, tert-butyl hydrazine or trimethylamine as nitrogen source.

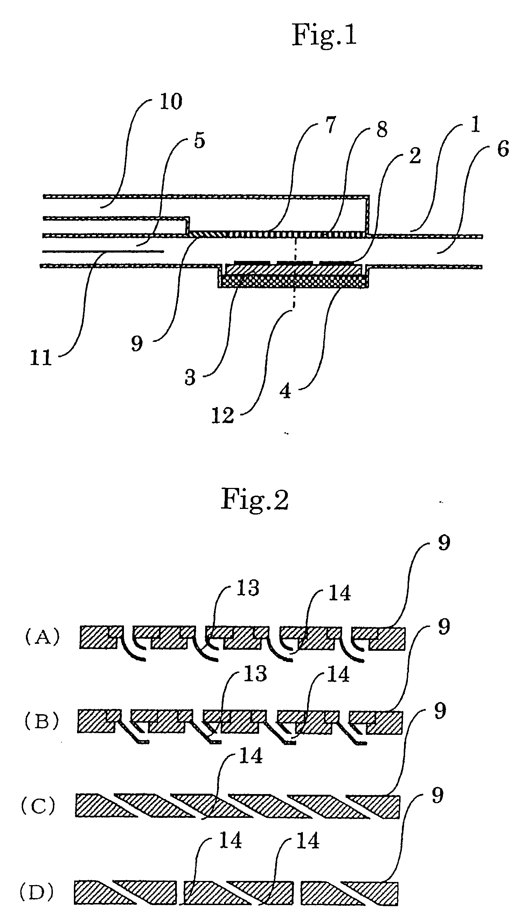

The chemical vapor deposition apparatus of the present invention will be described in further detail with reference to FIGS. 1 to 3, which does not limit the scope of the invention.

FIG.1 is a vertical sectional view showing an embodiment of a chemical vapor deposition apparatus of this invention. As shown in FIG. 1, a chemical vapor deposition apparatus of the present invention comprises horizontal type reaction tube 1 equipped with substrate 2, susceptor 3 to carry and rotate the substrate, heater 4 to heat the substrate, ingredient gas introduction division 5 arranged in a way that feeding direction to the reaction tube of the ingredient gas becomes substantially parallel to the substrate, and reaction gas exhaust division 6, at the same time, further providing pressurized gas introduction zone 7 on the wall of the reaction tube facing to the substrate, and the structure of at least one part 9 of the pressurized gas introduction zone 7 at an upstream side of an ingredient gas passageway such that the pressurized gas is fed in an oblique down or a horizontal direction oriented to a downstream side of the ingredient gas passageway.

In the chemical vapor deposition apparatus of the present invention, pressurized gas introduction zone 7 is arranged to a position where the flow of gas containing the ingredient gas receives the influence of heat from the heater. Therefore, although the position of pressurized gas introduction zone 7 cannot be limited unconditionally depending on the flow rate of the gas containing the ingredient gas, location of the heater, vapor phase epitaxy temperature, the dimension and the shape, etc. of the horizontal type reaction tube, it is usually arranged so that the center of the pressurized gas introduction zone will be at the neighborhood of position 12 corresponding to the center of the susceptor. Further, the contour or the cross section of the pressurized gas introduction zone is usually circular or elliptic, and the cross sectional area of it is around 0.5-5 times of the surface area of the susceptor.

In the case of promoting vapor phase epitaxy of semi-conductor film by the use of the horizontal type reaction tube according to this invention, although it is desirable to feed the pressurized gas into the reaction tube from the pressurized gas introduction zone, when the flow rate of the pressurized gas is small, there was a fear that the effect preventing scatter of the ingredient gas caused by the heat convection in the neighborhood of the substrate would decrease, and when the flow rate of the pressurized gas is large, there was a fear that bad influence would be given to vapor phase epitaxy of semi-conductor film on the substrate. However, according to the present invention, because the pressurized gas supplied from the pressurized gas introduction zone at an upstream side of an ingredient gas passageway is fed in an oblique down or a horizontal direction oriented to a downstream side of the ingredient gas passageway, it becomes possible to efficiently promote vapor phase epitaxy of a semi-conductor film with good uniformity and crystallinity on a heated substrate by eliminating the afore-mentioned fear.

FIG. 2 is a vertical sectional view showing a structure of an embodiment of the pressurized gas introduction zone 9 for feeding the pressurized gas obliquely downward or horizontally toward the downstream side of the ingredient gas passageway according to the invention. In this invention, although there is no limitation in particular regarding the structure, etc. of instruments or a supply opening of the pressurized gas introduction zone used to feed the pressurized gas obliquely downward or horizontally, instrument 13 is attached to the supply opening as illustrated, for example, in FIGS. 2(A) and 2(B), or the structure of the supply opening as shown in FIG. 2(C) is adopted.

Further, regarding the gas introduction zone 9, it is not necessary for all the gas supply opening to have the structure of supplying the pressurized gas obliquely downward or horizontally, a gas supply opening with the structure of feeding the pressurized gas down toward the substrate as shown, for example, in FIG. 2 (D) may be arranged in addition.

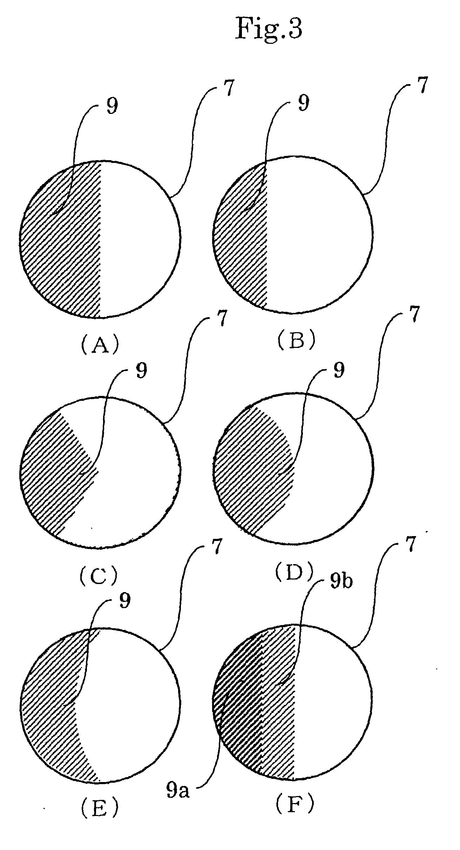

FIG. 3 is a plan view showing distributional examples of the pressurized gas introduction zone with the supply opening for feeding the pressurized gas obliquely downward or horizontally according to the present invention. In FIG. 3, the flowing direction of the ingredient gas is from left to right. In the chemical vapor deposition apparatus according to the present invention, the configuration of the afore-mentioned supply opening may be a semicircular shape section with slanted line as shown in FIG. 3(A) dividing upstream and downstream side of the pressurized gas introduction zone equally and, for example, may be a bow shape section with slanted line as shown FIG. 3(B), a fan shape section with slanted line as shown in FIG. 3(C), a convex lens shape section with slanted line as shown in FIG. 3(D), or a crescent shape section with slanted line as shown in FIG. 3(E).

Moreover, as shown in FIG. 3(F), a distribution changing step by step or continuously the feeding direction of the pressurized gas from horizontal direction to vertical direction toward the downstream side may be employed. Furthermore, a distribution changing step by step or continuously the ratio of said supply opening to the whole area of the pressurized gas introduction zone could be also employed. By arranging as above description, the feeding direction of the pressurized gas fed from the upstream side to the downstream side of the ingredient gas passageway can be changed smoothly from the horizontal direction to the vertical direction.

Further, in a chemical vapor deposition apparatus of this invention, as for pressurized gas introduction zone 9 to feed the pressurized gas obliquely downward or horizontally, it is usually arranged adjacently to pressurized gas introduction zone 8 to feed the pressurized gas down toward the substrate as shown in FIG. 1, however, being not limited to this, and pressurized gas introduction zone 9 may be arranged separately from pressurized gas introduction zone 8, for example, at 1-5cm upstream of the ingredient gas passageway.

Furthermore, as the construction materials for the pressurized gas introduction zone in a chemical vapor deposition apparatus of the present invention, although there is not any particular limitation, a porous quartz plate with micro-pores is usually employed because the decomposition product or reaction product of the ingredient gas is hard to precipitate. Regarding the diameter of the micro-pores, although there is no particular limitation, it is usually around in the range of from 0.1 to 3 mm and desirably around in the range of from 0.3 to 2 mm for the reason that in the case where the diameter is large, there is a fear of disturbing a homogeneous flow-out of the ingredient gas, and on the other hand, in the case where the diameter is too small, the required amount of gas flow cannot be obtained due to the increase of the pressure loss.

The structure of the ingredient gas introduction zone in this invention can be adopted either to the chemical vapor deposition apparatus of the structure with one supply opening of the ingredient gas introduction division or to the chemical vapor deposition apparatus of the structure partitioned into upper gas passageway and lower gas passageway with a partition plate or nozzle. Typical example of the structure partitioned into upper gas passageway and lower gas passageway with a partition plate or nozzle is a chemical vapor deposition apparatus having the upper gas passageway of the ingredient gas introduction division for supplying gas containing trimethylgallium, triethylgallium, trimethylindium, triethylindium, trimethylaluminum or triethylaluminium and having the lower gas passageway for supplying ammonia, monomethylhydrazine, dimethylhydrazine, tert - butyl hydrazine or trimethylamine.

Next, the chemical vapor deposition method of this invention will be described in detail. The present invention provides a chemical vapor deposition method of semi-conductor film on a substrate comprising the steps of supplying a gas containing ingredients in a way that feeding direction to the reaction tube of the gas becomes substantially parallel to the substrate, and supplying the pressurized gas from the pressurized gas introduction zone on the wall of the reaction tube facing the substrate characterized in that at least one part of the pressurized gas supplied from a pressurized gas introduction zone at an upstream side of an ingredient gas passageway is fed in an oblique down or a horizontal direction oriented to a downstream side of the ingredient gas passageway. In the chemical vapor deposition method of this invention, although a flow rate of the pressurized gas fed from the pressurized gas introduction zone is regulated to suppress the scattering of the ingredient gas caused by heat convection in the neighborhood of the substrate, and at the same time, not to give bad influence to vapor phase epitaxy of the semi-conductor film on the substrate, it is preferable to control so that the gas containing the ingredient gas supplied from the ingredient gas introduction zone passes over the substrate without changing the direction.

Therefore, although the feeding direction and the flow rate of the pressurized gas are not generally restricted because they depend on the location of the heater, the temperature of vapor phase epitaxy, the dimension or the shape of the horizontal type reaction tube, etc., usually the mean feeding direction of the pressurized gas in the upstream side of the ingredient gas passageway is from 15 to 75 degrees oblique against the direction of the ingredient gas passageway, and the average flow rate of the pressurized gas per the same surface area of the substrate is preferably from around 1/30 to 1/3 of the flow rate of the gas containing the ingredients and desirably from around 1/10 to 1/4.

Regarding said surface area of the substrate, it is defined as the area surrounded by the locus of the most outside contour illustrated by the edge surface of the substrate under the chemical vapor deposition. Further, regarding the pressurized gas employed in the chemical vapor deposition method of this invention, no limitation is particularly required as far as there is no influence on the vapor phase epitaxy reaction, and inert gas such as helium, argon, etc., or hydrogen, nitrogen, etc. can be employed.

In the chemical vapor deposition method of this invention, rotation and/or revolution of the substrate is desirable in order to efficiently promote homogeneous vapor phase epitaxy of the semi-conductor film on the substrate. Moreover, the chemical vapor deposition method according to the present invention is widely applicable to chemical vapor deposition at a temperature ranging from a relatively low temperature of about 600°C as a highest heating temperature of a substrate to a relatively high temperature of 1000 °C or higher. The inner pressure of the horizontal type reaction tube in the chemical vapor deposition method of this invention may be normal pressure, reduced pressure, or compressed state such as 0.1 MPa/cm²G.

In this invention, an ingredient gas means a gas that becomes a supply source of element taken into crystals as a crystal constituent element in the timing of a crystal growth. The kind of the ingredient gas is different depending on the kind of the semi-conductor film to be grown, and typically, metal hydrides such as arsin, phosphine, silane, etc., organometallic compounds such as trimethylgallium, trimethylindium, trimethylaluminum, etc., ammonia, hydrazine, alkyl amine, etc. are employed. Further, as the gas containing the ingredient gas, a gas fed after the dilution of the ingredient gas by the gas such as hydrogen, helium, argon, nitrogen, etc. may be used.

According to the chemical vapor deposition apparatus and the chemical vapor deposition method of the present invention, in the vapor phase epitaxy using the horizontal type reaction tube, it became possible to efficiently promotes vapor phase epitaxy of a semi-conductor film with good uniformity and crystallinity on the substrate even in the case of promoting the vapor phase epitaxy on large-scale substrate or promoting simultaneous vapor phase epitaxy on the substrate of plural pieces, or in the case of promoting the vapor phase epitaxy by adjusting at high temperature.

It is further understood by those skilled in the art that the foregoing description is a preferred embodiment of the invention and that various changes and modifications may be made in the invention without departing from the spirit and scope thereof.

In the following examples are described several preferred embodiments to concretely illustrate the invention, however, it is to be understood that the invention is not intended to be limited to the specific embodiments.

### Example 1

### [Preparation of a chemical vapor deposition apparatus]

A chemical vapor deposition apparatus mainly consisting of a horizontal type reaction tube made by quartz with a similar structure as the chemical vapor deposition apparatus shown in FIG. 1 was prepared. The dimension of this apparatus was 280 mm wide (a pressurized gas introduction zone), 20 mm high, and 1500 mm long by inner dimension. The susceptor and the heater were circular with the outside diameter of 260 mm, setting both one piece of the substrate at the center of the susceptor and five pieces of the substrate spacing with the same distance at the peripheral of the susceptor, totally six pieces of the substrate with a diameter of 2 inches were prepared to be simultaneously treated.

Further, the pressurized gas introduction zone with a circular contour assembled in a way that the bow-shaped portion as shown in FIG. 2 (B) feeds the pressurized gas horizontally was provided with the use of the quartz glass sintered body. The area of bow-shaped portion was 1/10 of the whole pressurized gas introduction zone.

Furthermore, the feeding amount of the pressurized gas per unit area of the pressurized gas introduction zone was settled to be equivalent at every point. Moreover, the area of the micro-pores parts of the pressurized gas introduction zone was 2 times of the area of the substrate.

### [Experiment on chemical vapor deposition]

By the use of afore-said apparatus, crystal growth of GaN was executed on the sapphire substrate with the diameter of 2 inches by the following procedures. Setting the sapphire substrate on the susceptor, and after having substituted the content within the reaction tube with hydrogen gas, while supplying hydrogen at 65 l/min from upper gas passageway of the ingredient gas introduction division, the heat treatment of the substrate was executed for 10 minutes by heating the substrate up to 1150 °C with feeding hydrogen gas at 20 l/min through the micro-pores of the pressurized gas introduction zone.

Next, lowering the temperature of the substrate down to 500 °C, left it until it was stabilized. Then, mixed gas of ammonia and hydrogen (ammonia 40 l/min, hydrogen 10 l/min) was supplied from the lower gas passageway of the ingredient gas introduction division and hydrogen gas containing trimethylgallium (trimethylgallium 240 µmol/min, hydrogen 50 l/min was supplied from the upper gas passageway of the ingredient gas introduction division. Moreover, nitrogen gas at 50 l/min was simultaneously fed through the pressurized gas introduction zone and cold temperature vapor phase epitaxy of GaN was executed for five minutes.

After the formation of a cold temperature growth layer, stopping the feeding of trimethylgallium and increasing the temperature up to 1100 °C, it was left until it was stabilized. Then, hydrogen gas containing trimethylgallium (trimethylgallium 240 µmol/min, hydrogen 50 l/min was supplied again from the upper gas passageway of the ingredient gas introduction division and sequentially nitrogen gas was fed at 50 l/min through the micro-pores, thereby vapor phase epitaxy of GaN was executed for 60 minutes. While the procedure, the susceptor was rotated at 12 rounds per minute and the substrate was rotated at 36 rounds per minute. In this way, the vapor phase epitaxy was repeated five times.

### [Evaluation, etc. of GaN film]

After vapor phase epitaxy closing, whether there was adhesion of solid matter to the wall of the reaction tube facing to the substrate or not was inspected. As a result the adhesion of solid matter was not recognized. Further, taking out the substrate, the distribution of GaN film thickness was measured and the uniformity of the thickness was evaluated. Because there was autorotation of the substrate during vapor phase epitaxy, the distribution of the film thickness was measured in the direction of from the center to the edge of the substrate.

The film thickness and the variation range ((maximum value ― minimum value)/mean value) of the thickness measured regarding both one piece of the substrate at the center of the susceptor and five pieces of the substrate at the peripheral of the susceptor are shown in Table 1. Furthermore, in order to evaluate crystalline quality and electrical characteristic of the film grown, the result of X-ray diffraction (half-value width of (002) face) and hole measurement (mobility) about the six pieces of the substrate were shown in Table 1.

Here, numeric values regarding the substrates at the peripheral of the susceptor are mean values of five pieces of the substrates, and this definition is equally adapted in Example 2 and the following examples.

### Example 2

A chemical vapor deposition apparatus with the same structure as Example 1 except substituting the pressurized gas introduction zone by the pressurized gas introduction zone with a circular contour assembled in a way that the convex lens shape portion as shown in FIG. 2 (D) feeds the pressurized gas horizontally was prepared with the use of the quartz glass sintered body. The convex lens shape portion was with the shape surrounded by the locus of a circle with the same dimension as the pressurized gas introduction zone having the center in the outside of periphery of the pressurized gas introduction zone and by the periphery of the pressurized gas introduction zone, and the area of the convex lens shape portion was 1/10 of the area of the whole pressurized gas introduction zone.

The vapor phase epitaxy experiment and the evaluation of GaN film, etc. were executed in the same way as Example 1 except employing this chemical vapor deposition apparatus. The results are shown in Table 1.

### Example 3

A chemical vapor deposition apparatus with the same structure as Example 1 except substituting the pressurized gas introduction zone by the pressurized gas introduction zone with a circular contour assembled in a way that the area of bow-shaped portion was 2 times as in the Example 1 feeds the pressurized gas obliquely in 45 degrees as against horizontal was prepared with the use of the quartz glass sintered body. The vapor phase epitaxy experiment and the evaluation of GaN film, etc. were executed in the same way as Example 1 except employing this chemical vapor deposition apparatus. The results are shown in Table 1.

### Example 4

A chemical vapor deposition apparatus with the same structure as Example 1 except substituting the pressurized gas introduction zone by the pressurized gas introduction zone with a circular contour assembled in a way that the feeding direction of the pressurized gas changes step by step from horizontal direction to vertical direction from the upstream side toward the downstream side as shown in FIG. 2(F) was prepared with the use of the quartz glass sintered body. The feeding direction of the pressurized gas was 60 degrees or 30 degrees slanted against horizontal, and the each area of the introduction zone was 1/10 of the area of the whole pressurized gas introduction zone.

The vapor phase epitaxy experiment and the evaluation of GaN film, etc. were executed in the same way as Example 1 except employing this chemical vapor deposition apparatus. The results are shown in Table 1.

### Comparative example 1

A chemical vapor deposition apparatus with the same structure as Example 1 except substituting the pressurized gas introduction zone by the pressurized gas introduction zone with a circular contour assembled in a way that feeds the pressurized gas downward as a whole toward the substrate was prepared with the use of the quartz glass sintered body. The vapor phase epitaxy experiment and the evaluation of GaN film, etc. were executed in the same way as Example 1 except employing this chemical vapor deposition apparatus. The results are shown in Table 1.

**[Table 1-1]**

| | shape of the pressurized gas introduction zone | feeding direction of the pressurized gas | position of the substrate | film thickness (µm) |
|---|---|---|---|---|
| Example 1 | FIG. 2(B) | Horizontal direction | Center | 1.24 |
| | (1/10) | | Peripheral | 1.15 |
| Example 2 | FIG. 2(D) | Horizontal direction | Center | 1.23 |
| | (1/10) | | Peripheral | 1.31 |
| Example 3 | FIG. 2(B) | 45 degrees | Center | 1.13 |
| | (1/5) | | Peripheral | 1.09 |
| Example 4 | FIG. 2(F) | 30 degrees 60 degrees | Center | 1.32 |
| | (1/5) | | Peripheral | 1.26 |
| Com. Ex. 1 | | Vertical direction | Center | 0.93 |
| | | | Peripheral | 0.86 |

**[Table 1-2]**

| | variation range of the thickness (%) | half-value width of X-ray diffraction (arcsec) | mobility (c m²) | adhesion of the solid matter |
|---|---|---|---|---|
| Example 1 | 1 | 318 | 204 | Nothing |
| | 2 | 309 | 207 | |
| Example 2 | 1 | 280 | 209 | Nothing |
| | 1 | 272 | 202 | |
| Example 3 | 2 | 321 | 192 | Nothing |
| | 1 | 326 | 201 | |
| Example 4 | 1 | 271 | 215 | Nothing |
| | 1 | 277 | 213 | |
| Com. Ex. 1 | 2 | 350 | 183 | Nothing |
| | 2 | 366 | 188 | |

In Table 1, Com. Ex. 1" means Comparative Example 1, and the lower numbers within parentheses in the column "shape of the pressurized gas introduction zone" represent the ratio of the area of the portion feeding the pressurized gas obliquely downward or horizontally divided by whole area.

From the afore-mentioned results, it was recognized that according to the chemical vapor deposition apparatus and the chemical vapor deposition method of this invention, GaN film having homogeneous and superior electrical characteristic was obtained without being influenced by the location of the substrate whether it is at the center portion of the susceptor or at the peripheral portion of the susceptor in vapor phase epitaxy of GaN requiring high-temperature of 1000 °C or more.

## Claims

1. A chemical vapor deposition apparatus of semi-conductor film comprising a horizontal type reaction tube equipped with a susceptor to carry a substrate, a heater to heat the substrate, an ingredient gas introduction zone arranged in a way that feeding direction to the reaction tube of the ingredient gas becomes substantially parallel to the substrate, and a reaction gas exhaust division, and further having a pressurized gas introduction zone on the wall of the reaction tube facing the substrate, wherein the structure of at least one part of the pressurized gas introduction zone at an upstream side of an ingredient gas passageway is such that the pressurized gas supplied from said part of the pressurized gas introduction zone is fed in an oblique down or a horizontal direction oriented to a downstream side of the ingredient gas passageway.

2. The chemical vapor deposition apparatus according to claim 1 wherein the contour of said pressurized gas introduction zone is circular or elliptic.

3. The chemical vapor deposition apparatus according to claim 1 wherein the configuration of said at least one part of the pressurized gas introduction zone is semicircular shape, bow shape, fan shape, convex lens shape or crescent shape.

4. The chemical vapor deposition apparatus according to claim 1 wherein the apparatus is of such constitution that plural of the substrates are mounted on the susceptor.

5. The chemical vapor deposition apparatus according to claim 1 wherein the apparatus is of such constitution that a large size substrate having a size of 4 inches (101.6 mm, approx.) or larger in diameter is mounted on the susceptor.

6. The chemical vapor deposition apparatus according to claim 1 wherein the apparatus is of such constitution that the gas passageway in the fingredient gas introduction zone is partitioned into upper gas passageway and lower gas passageway with a partition plate or a nozzle.

7. The chemical vapor deposition apparatus according to claim 6 wherein the upper gas passageway in the ingredient gas introduction zone is a passageway for the supply of a gas containing trimethylgallium, triethylgallium, trimethylindium, triethylindium, trimethylaluminum or triethylaluminuml, and the lower gas passageway in the ingredient gas introduction zone is a passageway for the supply of ammonia, monomethylhydrazine, dimethylhydrazine,
tert-butylhydrazine or trimethylamine.

8. A chemical vapor deposition method of semi-conductor film on a substrate comprising the steps of mounting a substrate on a susceptor in a horizontal type reaction tube, heating the substrate with a heater, and supplying a gas containing ingredients in a way that feeding direction to the reaction tube of the gas becomes substantially parallel to the substrate, and supplying the pressurized gas from the pressurized gas introduction zone on the wall of the reaction tube facing the substrate **characterized in that** at least one part of the pressurized gas supplied from a pressurized gas introduction zone at an upstream side of an ingredient gas passageway is fed in an oblique down or a horizontal direction oriented to a downstream side of the ingredient gas passageway.

9. The chemical vapor deposition method according to claim 8 wherein the maximum heating temperature of said substrate is 1000 °C or more.

10. The chemical vapor deposition method according to claim 8, wherein a gallium nitride compound semiconductor is subjected to chemical vapor deposition by using trimethylgallium, triethylgallium, trimethylindium, triethylindium, trimethylaluminum or triethylaluminium as III group metal source and by using ammonia, monomethylhydrazine, dimethylhydrazine, tert-butyl hydrazine or trimethylamine as nitrogen source.
